# EUROPEAN PATENT APPLICATION

(11) **EP 1 801 601 A1**
(43) Date of publication of application: **27.06.2007**
(21) Application number: 05112977.3
(22) Date of filing: 23.12.2005
(51) Int. Cl.: G01R 29/14, F41H 11/12, A01K 11/00, G01D 5/24

(54) **Electrostatic field imager**

(71) Applicant: The European Community, represented by the European Commission, 1049 Brussels (BE)
(72) Inventor: Coutsomitros, Constantin, Ranco 21020 (IT); Korn, Christophe, Geel 2440 (BE)
(74) Representative: Schmitt, Armand

(57) **Abstract**

An electrostatic field imager (24) comprises a sensor head with a plurality of passive sensing electrodes for sensing an electric field, the sensing electrodes (14) being arranged in a matrix, so as to be able of providing a 2D-image of the electric field. Grounded reference electrode (12) are arranged around the sensing electrode (14).

## Description

### Technical field

The present invention generally relates to the sensing of electric fields in the regime commonly referred to as "electrostatics" and in particular to an extremely sensitive electrostatic field imager.

### Background Art

The field of electrostatics, which concerns itself with electrical charges, potentials and forces, has first been studied in the 18^{th} and 19^{th} centuries. The most important instruments for exploring the world of electrostatics are electroscope or electrometer.

An electroscope usually comprises two thin gold leaves suspended from an electrical conductor inside an electrically insulating container. The electrical conductor is connected to an electrode outside the container. The electroscope indicates the presence of a charged body by the gold leaves standing apart at a certain angle. A charged body, which is brought close to or in contact with the electrode induces or transfers a like electric charge to each gold leaf, which in consequence repel each other.
An electrometer is usually an elaborate variant of a voltmeter with a very high input impedance (up to the order of 10¹⁵ Ohms). Such an electrometer can be used for sensing an electric field, e.g. caused by an electrostatically charged object.

### Object of the invention

It is an object of the present invention to provide an electrostatic sensor capable of providing a two-dimensional image of an electric field. This object is achieved by an electrostatic field imager as claimed in claim 1.

### General Description of the Invention

According to the invention, an electrostatic field imager comprises a sensor head with a plurality of passive sensing electrodes for sensing an electric field, the sensing electrodes being arranged in a matrix, so as to be able of providing a 2D-image of the electric field. In each sensing electrode, an electric current is induced by a variation of the electric field and can be detected by appropriate electronics. For instance, an amplification stage is preferably associated with the sensing electrodes, The amplification stage is configured to output a plurality of output signals, each one of the output signals being in response to a electric signal induced on a respective sensing electrode by the electric field. If it is appropriate to achieve high sensitivity, the input terminals of the amplification stage may present very high impedance. As shall be noticed, the electrostatic field imager is passive in the sense that it does not include an excitation electrode, which applies an alternative electromagnetic field to be sensed by a receiving electrode. Preferably, the sensing electrode matrix is rectangular or honeycombed, the distance between neighbouring sensing electrodes being smaller than the spatial electric field structures one wants to resolve.

In a preferred embodiment of the invention, the electrostatic field imager comprises a processing unit operationally connected to the amplification stage for producing a 2D-image of the electric field. Advantageously, the processing unit comprises display means for displaying the 2D-image of the electric field sensed and/or supplemental information related to the 2D-image. The display means can include a CRT display, an LCD display or the like. According to a very simple embodiment of the invention, the display means includes an array of LEDs, preferably disposed according to the matrix of the passive sensing electrodes. The intensity of light emitted by the LEDs may vary as a function of the electric field strength detected. An analog-to-digital (A/D) converter may be integrated into the electrostatic field imager for digitising the amplified signals.

Preferably, the electrostatic field imager comprises at least one grounded reference electrode, defining a reference potential and connected to the amplification stage.

As will be appreciated, the sensor head of electrostatic field imager may comprise a plastic screen to be electrically charged in an operational mode of the imager, the screen being associated with the plurality of sensing electrodes. By the presence of the charged screen, the electrostatic sensor can be used to detect conductive, uncharged objects, which are in movement with respect to the sensor head or the sensing electrode. The charged screen electrostatically induces a separation of positive and negative charges in the conductive object, which has an effect on the surrounding electric field. When the sensor head is moved with respect to the conductive object, this effect can be detected. The electrostatic field imager thus can provide a two-dimensional image of an electrically neutral conductive object, e.g. made of metal, located in front of the sensor head. The plastic screen can be mounted movably or removably on the sensor head in such a way that one can easily pass from one detection mode to the other, e.g. from electrostatic field imaging to metal detection.

According to another aspect of the invention, a method for detecting in a target area an electrostatically charged object, e.g. a plastic object, comprises the steps of:
providing an electrostatic field imager as presented above,
moving the electrostatic field imager relatively to the target area and
producing a 2D-image of the electric field.

A similar method addresses the detection of an initially uncharged object of electrically insulating material in a target area. In this case, one has to perform the additional step of applying an electric discharge to the target area, thereby electrically charging the object of electrically insulating material.

The skilled person will appreciate that the electrostatic field imager can be used for detecting landmines, especially low-metal landmines, e.g. by applying the methods above. Today, the most widely used tool for humanitarian demining is the metal detector. The principal drawbacks of metal detectors are the high false alarm rate and the difficulty of finding low-metal mines, e.g. mines composed of less than 0.5% of metal. In this context one may note that for about 20 years, almost all antipersonnel mines produced have been low-metal mines. Since mines are mostly composed of metal and plastic (besides of explosives) a plastic detector constitutes a good alternative or complementary detector for finding mines. Indeed, one can also integrate both metal and plastic detectors in a single mine detector. A landmine detector may for instance comprise an electrostatic field imager with a movable or removable plastic screen, which can be electrostatically charged and brought in front of the sensing electrodes. When the plastic screen is moved aside or completely removed, plastic objects can be detected, when it is in place, metal objects can be detected. It will highly be appreciated that the electrostatic field imager provides at least a coarse image of the object sensed, thus allowing determination of size and shape of the object.

Another interesting application of an electrostatic field imager is the in-vivo detection of a ruminal bolus ingested by a living being. Ruminal boluses are currently used for electronically identifying ruminants. A ruminal bolus is usually constituted by a body having an electronic device for storing and interchanging data, such as a passive RFID transponder unit, which is encapsulated in a capsule presenting a high resistance to the digestive juices and to the processes that take place in the pre-stomachs of ruminants. Materials used for fabricating the capsule include resins, high-density glasses, or materials based on alumina or silica. For identification of the animal, a reading device sends a query signal to the RFID transponder, which in turn emits a response signal containing some information about the ruminant, e.g. an identification code. In some cases, however, there is no response from the RFID transponder unit. Authorities my have an interest in determining if the bolus has intentionally not been put into place or if it is malfunctioning. To find out whether the RFID transponder has a defect or the bolus is not in place, there are presently two options, namely radiography with X-rays or post-mortal examination. Both methods involve prohibitive costs and are not suited for systematic testing. Detecting a bolus with an electrostatic field imager is a viable alternative, as it is non-lethal and involves reasonable costs.

A further application for the electrostatic field imager is contactless sensing of vibrations. To achieve this, the sensor head of the electrostatic imager is brought close to the object, the vibrations of which are to be measured. When the object is an electrical insulator, the electrostatic charges on its surface create an electric field that can be detected. As the object vibrates, the electric field varies accordingly, which is detected on the sensing electrodes of the electrostatic field sensor. In the other case of an electrically conductive object, there is the possibility of using a charged plastic screen on the sensor head. One could also attach one or more electrostatically charged patches to the surface of the object, for instance adhesive tape. In contrast to accelerometers, the electrostatic field imager is not in contact with the object, which allows an unbiased measurement. By means of the electrostatic field imager, the vibrational modes can be measured and studied.

### Brief Description of the Drawings

Preferred embodiments of the invention will now be described, by way of example, with reference to the accompanying drawings in which:
- Fig. 1:: is a perspective view of an experimental setup for illustrating the basic measurement principles of an electrostatic field sensor;
- Fig. 2:: is a perspective view of an electrostatic field imager adapted for spatially resolved detection of electrostatically charged objects;
- Fig. 3:: is a perspective view of an electrostatic field imager adapted for spatially resolved detection of electrostatically charged objects or electrically neutral conductive objects;
- Fig. 4:: is a perspective view of an alternative embodiment of a sensor head for spatially resolved detection of electrostatically charged objects or electrically neutral conductive objects;
- Fig. 5:: is a simplified block diagram of the electrical circuits of an electrostatic sensor as in Figs. 2 and 3;
- Fig. 6:: is an illustration of an electrostatic imager used for ruminal bolus detection;
- Fig. 7:: is a perspective view of a landmine detector comprising an electrostatic field imager.

### Description of Preferred Embodiments

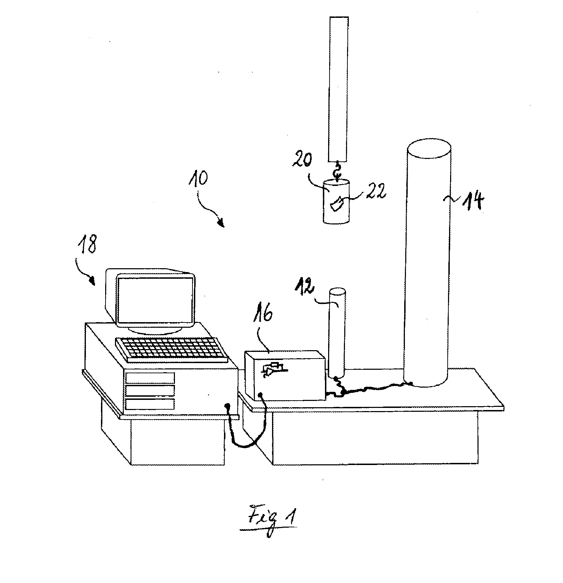

The basic measurement principles will now be explained with reference to Fig. 1. The shown electrostatic field sensor 10 can remotely detect extremely small electrostatic field variations caused by an electrically insulating object at rest or in movement with respect to the sensor. The electrostatic field sensor 10 comprises two metal electrodes 12, 14, which generally can have any size and geometrical shape, for instance rectangular, circular or, as illustrated in Fig. 1, cylindrical. One of the electrodes is grounded 12 and defines the reference potential, the other electrode 14 is the sensing electrode. The material of the electrodes may be any good conductor, e.g. copper, gold, silver, aluminium, nickel, etc. It will be appreciated that the sensor's sensitivity increases with the size of the sensing electrode. The electrodes 12, 14 are connected to a high-impedance amplification stage 16, which in turn transmits the amplified signals to a computer 18 equipped with an A/D converter. There are several applications of such a sensor, e.g. position determination in robotic applications, remote vibration measurements, detection of electrostatic phenomena in the atmosphere, contactless eavesdropping of electronic communications in a cable or wire, segregating different plastic materials, etc. Among the detection of electrostatic phenomena in the atmosphere, one may mention the detection a localisation of meteorites. The measurement principles shall hereinafter be explained on the example of spatial position determination of an object, which can be achieved with interferometric accuracy.

A metal body 20 is suspended from the lab room ceiling and may freely swing. If the metal body 20 has been electrically charged previously, its movements with respect to the electrodes 12, 14 induce small currents in the sensing electrode 14, which can be amplified in the amplification stage 16 and then detected by the computer 18. In the shown case of an electrically neutral metal body 20, it is sufficient to attach on it an electrostatically charged piece of adhesive tape 22. The electrostatic field caused by the adhesive tape couples to the sensing electrode 14, so that the movements of the charged tape 22 induce a measurable current on the sensing electrode 14. Experiments under lab conditions have shown that currents of 10⁻¹⁷ Amperes in the sensing electrode can be detected. The sensitivity of the system 10 is thus extraordinarily high and the achieved precision is comparable to interferometric measurement techniques, with the distance from the electrodes 12, 14 and the object to be sensed being up to three metres.

One can connect further sensing electrodes to the electrostatic field sensor and distribute them in or around a region, where one wants to determine the position of an object. The computer calculates the position by using triangulation methods. Such an arrangement could e.g. be used in robotic applications or, at a larger scale, for localising meteorites entering earth atmosphere. With suitable calibration, the system can be used to determine the amount of energy released by a meteorite during its entering into atmosphere.

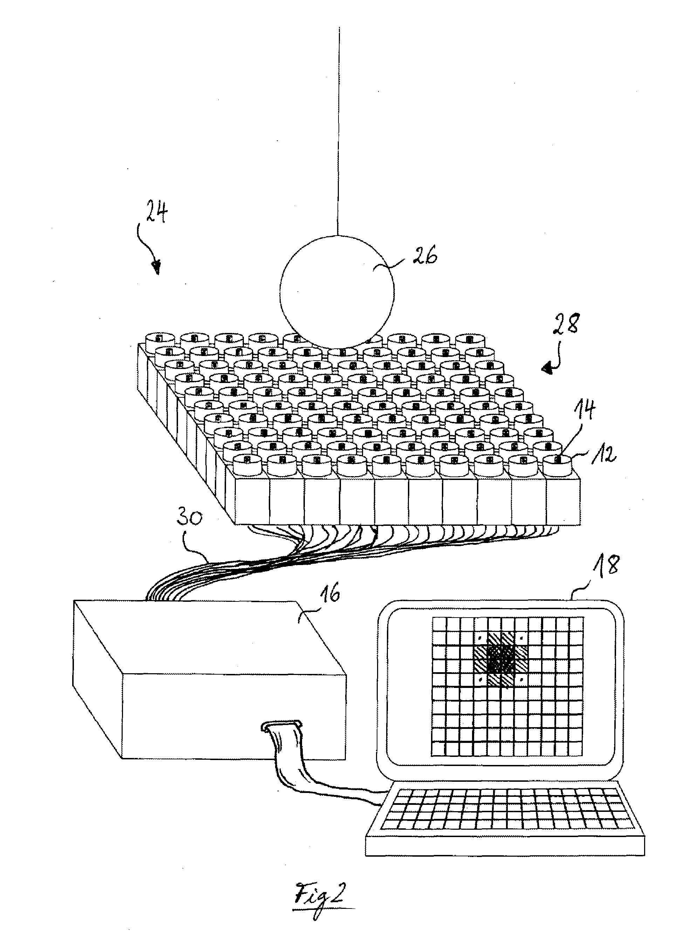

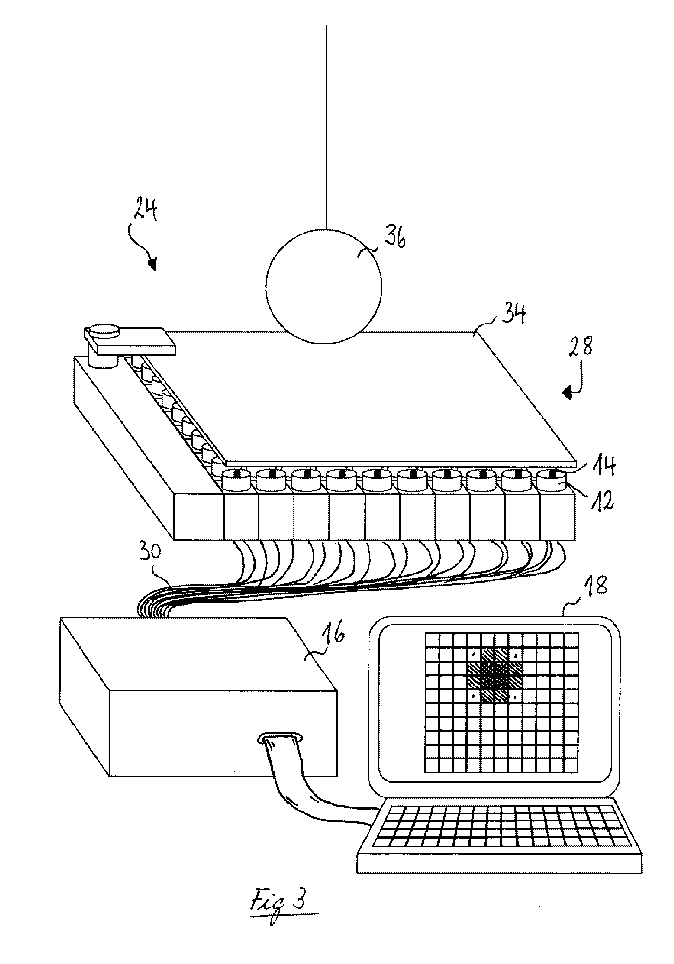

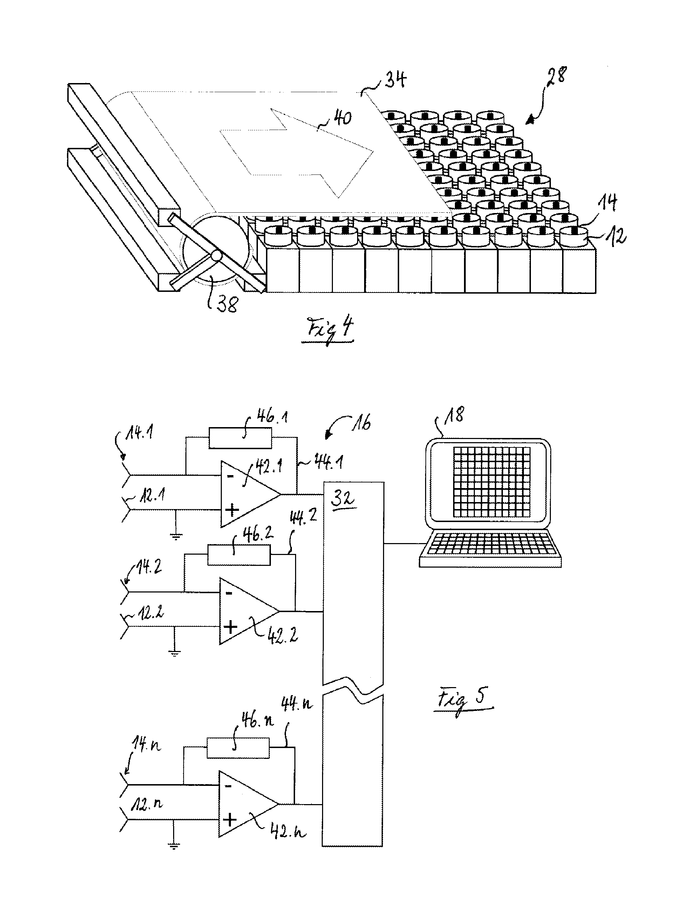

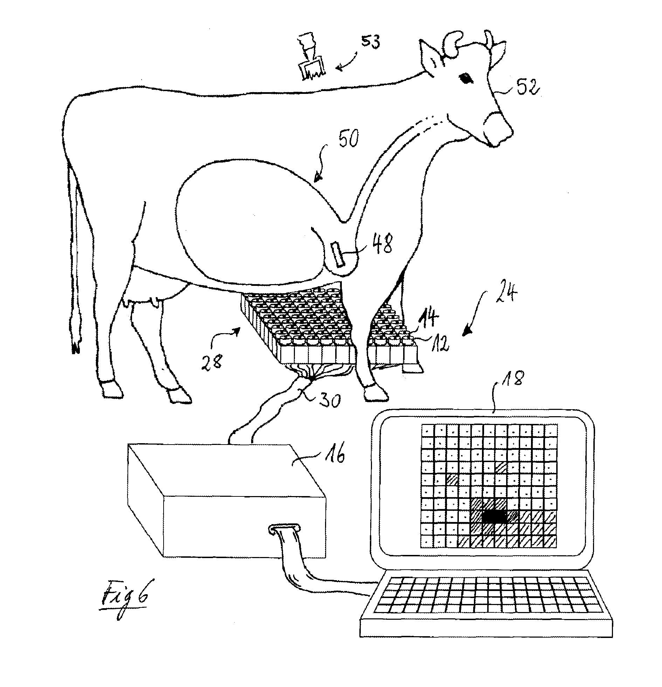

Fig. 2 shows an electrostatic field imager 24 adapted for spatially resolved detection of electrostatically charged objects. A plastic ball 26 is suspended from the ceiling and its movements are to be detected by the electrostatic field imager 24. The sensor head 28 comprises a 10x10 array of sensing electrodes 14. Grounded reference electrodes 12 are arranged laterally around the sensing electrodes 14. The sensing electrodes 12 are electrically connected to amplification circuits inside the amplification unit 16. The signals of sensing electrodes 14 are separately provided to the amplification unit by shielded cables or wires 30 (not all of them shown in the figure) and amplified by an adjustable factor. The input impedance of the amplification circuits is extremely high (up to 10¹⁵ Ohms), so that virtually no current is drawn from the sensing electrodes 14. The amplified signals are provided to a multiplexer 32 (see Fig. 5), which produces a multiplexed output signal. The multiplexed output signal is provided to a computer 18, where it is analysed. Depending on the application, the computer 18 can display a 2D-image of the received signal amplitudes, store the amplitudes in memory and/or identify certain features in the image.

For detecting the plastic ball 26, the sensor head 28 is in movement with respect to it. The skilled person will appreciate that it can actually be the plastic ball 26 that moves while the sensor head 28 is at rest.

The electrostatic field imager 24 of Fig. 2 can for instance be used for imaging the modes of a vibrating object, e.g. an engine. With its extremely high impedance, displacements in the sub-micrometer range of electrostatically charged structures can be remotely detected.

It is furthermore possible to provide an image of the electric field inside a car. As the car is imperfectly grounded, electrostatic charges inside the car can create slight, yet detectable potential variations on the surrounding metal structures. Imaging these potential variations by means of the electrostatic field imager, one can "look" through the metal sheets of the car. The same principle can be applied to "look" through any imperfectly grounded conductive wall or structure.

Fig. 3 shows an electrostatic field imager 24, wherein an additional plastic screen 34 is rotatably mounted on the sensor head 28. The plastic screen 34 can be rotated from an active position, wherein it substantially covers the sensing electrodes 14, to an inactive position, wherein it is not between the sensing electrodes 14 and the object to be sensed (the metal ball 36 in Fig. 3). In its active position, the plastic screen 34 can be electrostatically charged, which enables the electrostatic field imager 24 to image electrically uncharged conductive bodies, for example the metal ball 36. In addition, the electrostatic field imager 24 may be used for recording a spatially resolved electroencephalogram or electrocardiogram. A two-dimensional map of the brain or heart activity may thus be obtained. In certain cases, it may prove useful if the sensing electrodes are arranged on a curved surface, for example on the inner side of a hood, which is put over a patient's head for taking an electroencephalogram at several points of the head. As the sensing electrodes need not being in contact with the patient's skin, the patient's comfort during the measurement is greatly enhanced with regard to traditional methods.

The sensor head 28 preferably comprises an electric motor, which drives the plastic screen 34 from its active to its inactive position. The plastic screen 34 can also be achieved as a curtain (see Fig. 4), which is rolled up on a cylinder 38 in its inactive position and which can be moved, manually or automatically, over the sensing electrodes 14 along the direction indicated by arrow 40. The plastic may be chosen such that the rolling off from the cylinder 38 creates the electrostatic charges on the plastic screen 34. An additional charging step can thus be omitted.

A simplified block diagram of the electrical circuits of an electrostatic imager as in Figs. 2 and 3 is shown in Fig. 5. A plurality of passive sensing electrodes 14.1, 14.2, ..., 14.n (n being a positive integer) are connected to an amplification stage 16, which comprises at least one first low-noise operational amplifier 42.1, 42.2, ..., 42.n associated with each sensing electrode 14.1, 14.2, ..., 14.n. In certain embodiments, the output of the first low-noise operational amplifier is connected to an input of a second low-noise operational amplifier to achieve the desired gain. It will be appreciated that the signals on the sensing electrodes 14.1, 14.2, ..., 14.n are amplified individually. The ultrahigh impedance of the amplification stage is achieved by the feedback loops 44.1, 44.2, ..., 44.n. The gain can be adjusted by changing the resistance 46.1, 46.2, ..., 46.n of the feedback loops 44.1, 44.2, ..., 44.n. The system may comprise a manual switch for doing so but preferentially, it comprises an automated means for adjusting the gain to an optimal value, depending on the amplitude of the sensed signal. After amplification, the signals are fed to a multiplexer 32, which preferably operates at a rate above 30 Hz, still more preferably between 50 to 100 Hz. Advantageously, the circuits comprise a filtering stage, which eliminates undesired frequency components, like for instance the 50-Hz- or 60-Hz-peak caused by mains. Such a filtering stage may be integrated into the multiplexer 32. The multiplexed signal is fed to a computer 18, which is equipped with an analog-to-digital converter and wherein the signal is demultiplexed. The individual signals of the sensing electrodes can thus be retrieved, analysed, filtered by software, displayed and/or stored in memory.

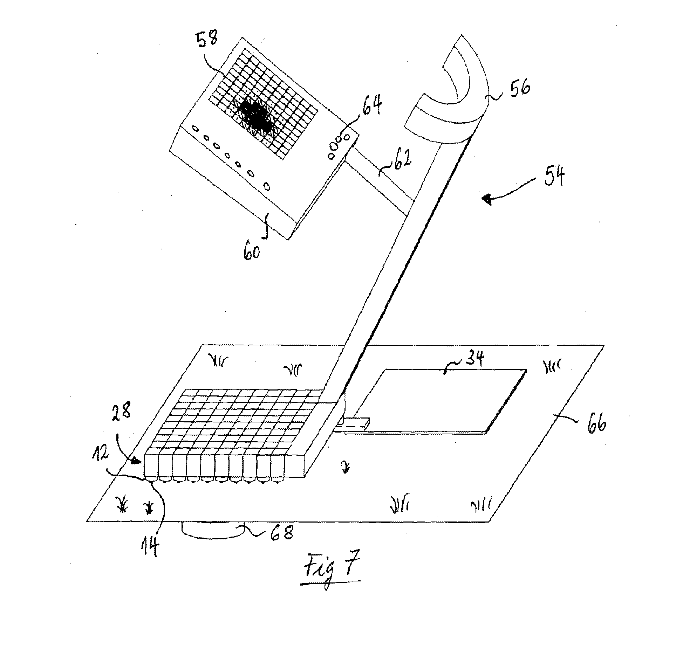

Fig. 6 illustrates the use of an electrostatic field imager for detecting a ruminal bolus. In order to detect the presence of a dysfunctional ruminal bolus 48 in the digestive tract 50 of a ruminant 52, a sensor head 28 of an electrostatic field imager 24 is arranged next to the ruminant's body, and an electric field is generated at or from behind the ruminant's body, e.g. by creating a small electric discharge behind the ruminant or on the ruminant as shown at 53. The term "behind" is used here with respect to the electrostatic field imager. As the bolus 48 contains a certain amount of electrically insulating material, it alters the electric field caused by the discharge, which can be detected by the electrostatic field imager 24. The bolus normally consists an elongated substantially cylindrical capsule of about 7 cm long and about 2 cm in diameter. When an insulating object is detected inside the ruminant 52, the sensor head 28 can be moved in order to determine the shape of the detected object under different angles. From these observations, it can be easily concluded with high certainty whether the detected object is a ruminal bolus or not.

Fig. 6 illustrates the use of an electrostatic imager for detecting landmines. First, one has to understand that electrostatic charges remain a long time on the plastic parts of a mine, especially if the soil is dry. The electrostatic field created by these charges can be detected by an electrostatic field imager as described above.

The situation may nevertheless occur that the plastic parts of a mine wear less than a detectable amount of electrostatic charges. It is therefore recommended, especially for humid soil, to first apply an electrostatic discharge to the area that is to be scanned. This can be done by approaching to the ground an electrode at a high electric potential or by using a stun gun (delivering electric discharges of the order of 10⁵ V)..

Experiments with dummy mines have shown that even mines, which had been covered with a metal plate can be reliably detected by means of the electrostatic field imager. As a matter of fact, the field created by the electrostatic charges on the mine is not completely stopped at the metal plate due to imperfect grounding. One thus observes an attenuation of the signals on the sensing electrodes, but detection is still possible.

The landmine detector 54 comprises an integrated electrostatic field imager. The shaft of the battery-powered detector 54 has an armrest 56 on its first end and a sensor head 28 on its second end, which is opposed to the first end. The sensor head comprises a sensing electrode matrix, which faces the ground when the detector is in use. In this case, the matrix is rectangular with ten rows and ten columns, but these numbers and the shape of the matrix may vary. A grounded reference 12 electrode is arranged laterally around each sensing electrode 14. The landmine detector 54 further comprises an amplification stage for amplifying the signals of the sensing electrodes and an A/D converter for digitising the amplified signals. A processing unit is integrated into the detector 54, which analyses the digitised signals. A display 58 is included, which provides in real time a 2D-image of the sensed electric field. As shown in Fig. 6, the display 58 can be an LCD integrated into a control unit 60 on the detector handle 62, by which the detector 54 can be carried. Preferably, the most used control buttons 64 are located on the handle or next to it on the control unit 60 in such a way that the user can actuate them with only one hand, e.g. with the thumb. Those skilled will appreciate that the display 58 could also comprise an a matrix of LEDs, which probably makes the mine detector 54 more affordable and lighter. Moreover, the display 58 can be arranged on the upper side of the sensor head 28.

The sensor head 28 comprises an additional plastic screen 34 rotatably mounted thereon. The plastic screen 34 can be brought into an active position, where it is located between the sensing electrodes and the ground 66 or in an inactive position. In its active position, the plastic screen can be electrostatically charged, which enables the landmine detector 54 to detect buried conductive bodies, in particular the metal parts of a mine.

The handling of the present landmine detector 54 is very similar to metal detectors commonly used for de-mining. The user swings the sensor head 28 at more or less constant speed in small arcs over the track he intends to take. The detection principle is the same as above: when the sensing electrodes move with respect to the electrostatically charged plastic parts of a mine 68, currents are induced in the sensing electrodes 14, which can be measured and used for providing an image of the electric field. This image can be directly displayed so that the user may immediately decide whether the detected electric field is caused by a mine 68. In order to facilitate the user's task, the detector 54 preferably comprises a discriminator, which analyses the structures of the detected electric field, for instance by comparing these structures with stored ones in a database. In case one of the stored structures matches an actually detected structure, the detector can emit an audible and/or visible alarm. Preferably, the discriminator takes into account environmental conditions, such as humidity, temperature, soil consistency, etc.

The user can perform a second sweep over the area in front of him, with the plastic screen 34 in its active position. During the second sweep, metal parts are detected. The combined results of the two sweeps constitute an improved basis for evaluating the situation. In elaborate versions of the mine detector 54, the processing unit may be able to automatically combine the images of the two sweeps.

It will be appreciated that the electrostatic field imager can be combined with other mine detection devices for increasing their reliability.

### List of Reference Numerals

- Electrostatic field sensor: 10
- Reference electrode: 12
- Sensing electrode: 14, 14.1, 14.2, ..., 14.n
- Amplification unit: 16
- Computer: 18
- Metal body: 20
- Adhesive tape: 22
- Electrostatic field imager: 24
- Plastic ball: 26
- Sensor head: 28
- Cables or wires: 30
- Multiplexer: 32
- Plastic screen: 34
- Metal ball: 36
- Cylinder: 38
- Arrow: 40
- operational amplifier: 42.1, 42.2, ..., 42.n
- feedback loops: 44.1, 44.2, ..., 44.n
- resistance: 46.1, 46.2, ..., 46.n
- ruminal bolus: 48
- digestive tract: 50
- ruminant: 52
- electric discharge: 53
- mine detector: 54
- armrest: 56
- display: 58
- control unit: 60
- detector handle: 62
- control buttons: 64
- ground: 66
- mine: 68

## Claims

1. An electrostatic field imager **characterised by** a sensor head with a plurality of passive sensing electrodes for sensing an electric field, said sensing electrodes being arranged in a matrix, so as to be able of providing a 2D-image of said electric field.

2. An electrostatic field imager according to claim 1, comprising an amplification stage associated with each one of said sensing electrodes for outputting a plurality of output signals, each one of said output signals being in response to a electric signal induced on a respective sensing electrode by said electric field.

3. An electrostatic field imager according to claim 1 or 2, comprising a processing unit operationally connected to said amplification stage for producing a 2D-image of said electric field.

4. An electrostatic field imager according to any one of the preceding claims, comprising a grounded reference electrode connected to said amplification stage.

5. An electrostatic field imager according to any one of the preceding claims, wherein said sensor head comprises an plastic screen to be electrically charged in an operational mode of said imager, said screen being associated with said plurality of sensing electrodes.

6. A method for detecting an electrostatically charged object in a target area, comprising the steps of:
providing an electrostatic field imager according to any one of claims 1 to 5;
moving said electrostatic field imager relatively to said target area,
producing a 2D-image of said electric field.

7. A method for detecting an initially uncharged object of electrically insulating material in a target area, comprising the steps of:
providing an electrostatic field imager according to any one of claims 1 to 5;
applying an electric discharge to said target area, thereby electrically charging said object of electrically insulating material;
moving said electrostatic field imager relatively to said target area,
producing a 2D-image of said electric field..

8. Use of an electrostatic field imager according to any one of claims 1 to 5 for detecting landmines.

9. Use of an electrostatic field imager according to any one of claims 1 to 5 for the in-vivo detection of a ruminal bolus ingested by a living being.

10. Use of an electrostatic field imager according to any one of claims 1 to 5 for contactlessly measuring vibrations of an object.
